(19) Europäisches Patentamt
European Patent Office
Office européen des brevets

(11) Publication number: **0 210 851 B1**

(12) **EUROPEAN PATENT SPECIFICATION**

(45) Date of publication of patent specification: **18.03.92**

(51) Int. Cl.5: **C08G 73/10**, C08G 73/14, C08L 79/08

(21) Application number: **86305754.3**

(22) Date of filing: **25.07.86**

(54) **Mixtures of polyamideimides, containing 3,4'-diaminodiphenylether as diamine component, and of a plasticizer.**

(30) Priority: **26.07.85 JP 163864/85**
**18.09.85 JP 204321/85**

(43) Date of publication of application:
**04.02.87 Bulletin 87/06**

(45) Publication of the grant of the patent:
**18.03.92 Bulletin 92/12**

(84) Designated Contracting States:
**DE FR GB**

(56) References cited:
**EP-A- 0 179 604** **FR-A- 1 420 021**
**US-A- 3 860 559** **US-A- 4 094 862**
**US-A- 4 448 907** **US-A- 4 524 171**

**PATENT ABSTRACTS OF JAPAN, vol. 10, no. 321 (C-382)[2377], 31st October 1986; & JP - A - 61 130 342 (HITACHI CHEM CO LTD) 18-06-1986 (Cat. P,X)**

**CHEMICAL ABSTRACTS, vol. 85, no. 18, 1st November 1976, page 52, column 1, abstract no. 125094v, Columbus, Ohio, US; & JP - A - 76 10266 (TORAY INDUSTRIES INC.) 02-04-1976**

(73) Proprietor: **TEIJIN LIMITED**
**11 Minami Honmachi 1-chome Higashi-ku**
**Osaka-shi Osaka-fu(JP)**

(72) Inventor: **Hara, Shigeyoshi**
**3-1-3, Yamate-cho**
**Iwakuni-shi Yamaguchi-ken(JP)**
Inventor: **Inata, Hiroo**
**6-49-5, Hirata**
**Iwakuni-shi Yamaguchi-ken(JP)**

(74) Representative: **Myerscough, Philip Boyd et al**
**J.A.Kemp & Co. 14, South Square Gray's Inn**
**London, WC1R 5EU(GB)**

**EP 0 210 851 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to shapeable intimate mixtures of (A) polyamideimides obtained by using 3,4'-diaminodiphenylether as a diamine component and (B) certain plasticizers.

Polyimides gained commercial acceptance as typical thermally stable resins in the early 1960s and have been used in various applications.

A typical polyimide is poly-4,4'-oxydiphenylenepyromellitimide of the following formula.

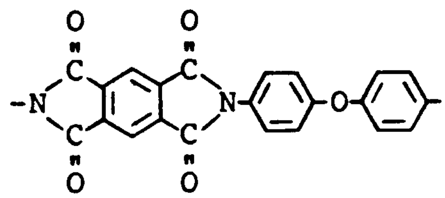

This polyimide has excellent thermal stability, heat resistance and flexibility, and is commercially available from E. I. du Pont de Nemours & Co. as a film under a registered trademark Kapton®.

As is well known, this polyimide having the structure shown above has the difficulty that because it is insoluble and infusible, it can be fabricated only by sintering its powder at high temperatures and pressures as is the case with ceramics.

This difficulty is avoided by utilizing the fact that a polyadduct, i.e. polyamic acid, obtained by reacting the starting pyromellitic dianhydride with 4,4'-hyroxydianiline at room temperature or below is soluble in polar solvents such as N-methylpyrrolidone. The polyamic acid is dry- or wet-shaped, and dehydrocyclized by the action of a cyclizing agent and/or heat-treatment during or after shaping to convert it into the polyimide having the above formula. This method generally requires heating for a long period of time during or after shaping, and water formed as a by-product by the cyclization reaction should be released out of the reaction system. This method can be applied to the formation of articles having a high specific surface area such as films or fibers, but is difficult to apply to the production of adhesives, matrix resins for composite materials, heat melt-shaping resins, etc. which are used in a form in which the by-product water can be taken out easily out of the system.

U.S.-A-3,890,274 discloses phthalonitrile-terminated aromatic polyimides having an orthodicyanoaromatic radical at both ends of the polymer chain. The patent describes that when the polyimides are heated to about 180 to 300 °C, or reacted with polyvalent metals, high molecular, infusible, insoluble polymers are produced.

GB-A-1,457,191 discloses that a polyimide, or its obvious poly(amic acid) equivalent, including the repeating unit

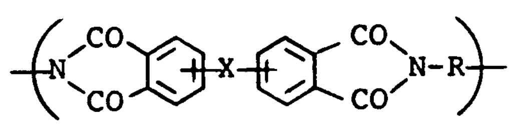

wherein X is

$$-(CH_2)_n-$$

or a mixture of

$$-(CF_2)_n-$$

and -CO-, n is an integer from 2 to 8, and R represents divalent aromatic groups having the formula

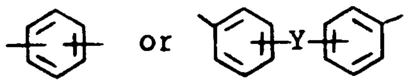

wherein Y is a divalent linking atom or group, together with a proportion of arsenic thioarsenate, provides an adhesive composition.

U.S.-A-3,996,196, a divisional of U.S.-A-3,890,274, discloses a polyimidemetallo-phthalocyanine in such a form that the aforesaid phthalonitrile-terminated aromatic polyimides are bonded by polyvalent metals.

U.S.-A-4,197,397 discloses polyimides represented by the following formula

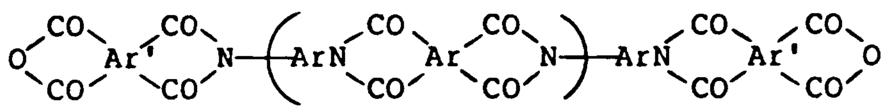

wherein Ar' is a tetravalent aromatic organic radical, Ar is an n-valent aromatic organic radical, and n is a positive integer of at least 2,
and the corresponding polyimide-polyamic acid.

U.S.-A-4,220,750 discloses enyne polyimides lightly crosslinkable on thermal treatment including the unit

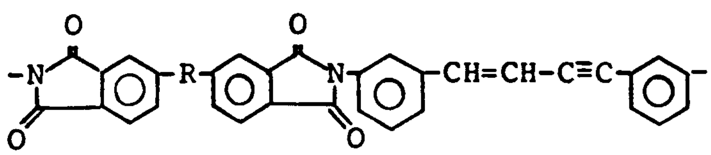

wherein R is S, $SO_2$, CO or a divalent aromatic aliphatic or perfluoroaliphatic radical.

U.S.-A-4,320,217 discloses polyimides having terminal acetylenic amide groups. The patent describes that these polyimides give crosslinked, insoluble, infusible polymers.

U.S.-A-4,321,198 discloses polyimides having acetylenic amide groups with terminal =C≡CH groups as hemi-amic acid groups.

JP-A-3603/1983 discloses a process for producing a dry separation membrane of polyimide, which comprises wetting a wet coagulated membrane prepared from a dope of an aromatic polyamic acid or an aromatic polyimide with an organic solvent having a solubility parameter of 5 to 9.4, and then drying the membrane.

JP-A-8513/1983 and the corresponding U.S. -A-4,528,004 disclose a process for producing a composite separation membrane of polyimide, which comprises coating a dilute solution composed of a halogenated hydrocarbon, a phenol and a soluble polyimide on a microporous membrane of an aromatic polyimide, and then drying the coated membrane.

JP-A-11003/1983 and the corresponding U.S. -A-4,474,858 disclose a polyimide gas separation membrane effective for the separation of hydrogen gas and carbon monoxide from each other and the separation of nitrogen gas and oxygen gas from each other.

JP-A-11006/1983 and the corresponding U.S. -A-4,528,004 disclose a process for producing a gas separation membrane of polyimide having the properties described in the above-cited JP-A-11003/1983.

JP-A-95029/1986 and the corresponding EP-A-0179604 disclose "the polyimide powder for adhesion and/or coat forming, which comprises the polyimide powder being obtained by chemically imidizing a polyamic-acid having recurring units of the formula (I):

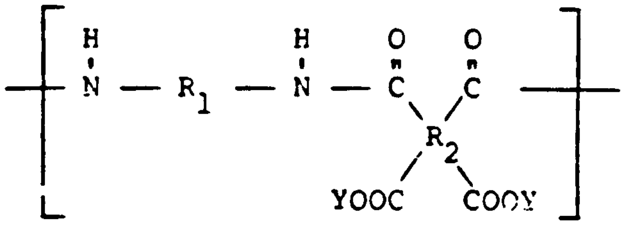

(I)

where $R_1$ is selected from the group consisting of

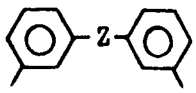 and 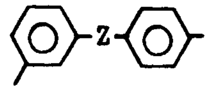 ;

$R_2$ is selected from the group consisting of

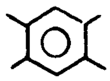 and 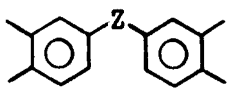 ;

Z is selected from the group consisting of

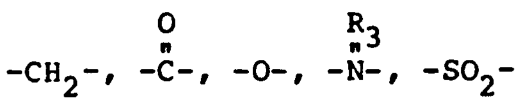 and -S- ;

$R_3$ is selected from the group consisting of alkyl and aryl, and Y is selected from the group consisting of hydrogen, alkyl and aryl, with an imidizing agent, and having recurring units of the formula (II):

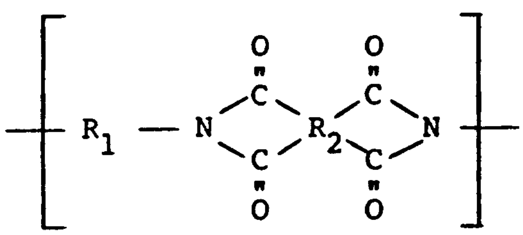

(II)

wherein $R_1$ and $R_2$ are the same as $R_1$ and $R_2$ in the formula (I)." (sic.) However, these documents do not at all describe polyimides in which $R_1$ is

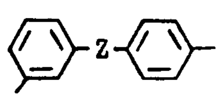

and Z is -O-, and $R_2$ is

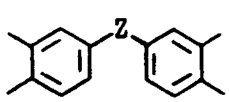

and Z is -CO-.

JP-A-95030/1986 discloses a process for producing a film of a polyimide composed substantially of recurring units represented by the same formula as formula (II) in the above-cited JP-A-95029/1986, which comprises casting a solution prepared by mixing a dehydroimidization agent to an organic solvent solution of a polyamic acid having recurring units represented by the same formula as formula (I) disclosed in JP-A-95029/1986 on a support, chemically imidizing the polymer, and molding the resulting product.

JP-A-95031/1986 discloses a process for producing a film which is the same as the process described in JP-A-95030/1986 except that an organic solvent solution of the polyamic acid is cast on a support and then reacted with a dehydroimidizing agent.

Neither JP-A-95030/1986 nor JP-A-95031/1986 discloses a polyimide in which $R_1$ is

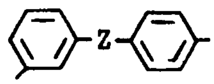

and Z is -O-, and $R_2$ is

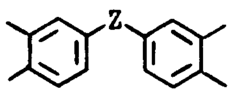

and Z is -CO-.

As the above-cited prior art references show, there have been two large trends in improving the processability of polyimides, namely (a) the production of polyimides which can be molded and thereafter heat-cured by attaching to the terminals of oligoimide, groups which cure by addition reaction to form bonds having good thermal stability, and (b) the production of thermoplastic polyimides having modified main-chain structures.

These trends will be described briefly with reference to specific examples.

As examples of the former, PBR series using Nadic acid anhydride terminals (developed by NASA, U. S. A.) and Termid® using phenylacetylene groups have gained commercial acceptance. The resins of the former, however, have the defect that after the resins have reached a B-stage, long periods of time are required to form cured resins by the reaction of the terminal groups, and the resulting cured resins do not have entirely good flexibility.

In contrast, the latter polyimides, when heated to temperatures before the fusing temperature, have reduced strength and are likely to undergo fracture. However, they have the advantage that they can be molded to cured resin articles by melt-fusing within short periods of time, and they are essentially high-molecular-weight linear polymers and have excellent flexibility. Hence, they can be used preferably in applications requiring flexibility, for example as adhesives. NR150 of E. I. du Pont de Nemours & Co., polyimide 2080 of Up-John Co. and LARC-TPI developed by NASA may be cited as resins falling within the polyamides (b) above.

It is said that NR150 has a structure represented by the following formula

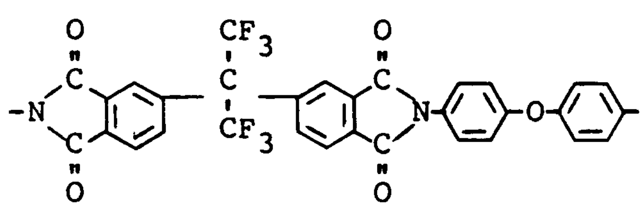

Since it uses a special fluorine-containing tetracarboxylic dianhydride, its price becomes very high.

Polyimide 2080 is considered to be obtained by the reaction of benzophenonetetracarboxylic acid dianhydride, 4,4'-diphenylmethane diisocyanate and tolylene diisocyanate. It is said that this polyimide is inexpensive, but since it has methylene and methyl groups in the main and side chains, it is unstable to oxidation and has inferior thermal stability.

It was reported that LARC-TPI has a structure of the following formula:

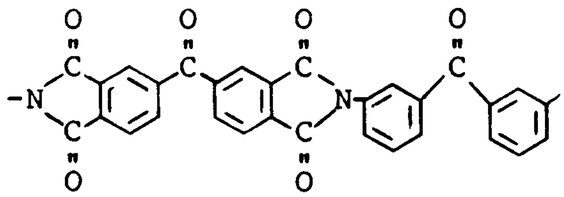

It has excellent heat melt-adhesion. It has been pointed out however that since it starts from 3,3'-diaminobenzophenone, a special diamine, as a starting material and is composed of considerably rigid benzophenone bonds alone, it has insufficient flexibilty in certain applications.

Aromatic polyamideimides containing an aromatic tricarboxylic acid or an aromatic tricarboxylic acid anhydride as an acid component, which differ from the aromatic polyimides described above, have also been known heretofore.

JP-A-180352/1983 discloses a process for producing an aromatic polyamideimide from the aforesaid acid component and an aromatic diamine in the presence of a dehydration catalyst using a solvent containing sulfolane. Example 6 of this patent document describes that 20g (0.1 mole) of 3,4'-diaminodiphenylether and 19.2g (0.1 mole) of trimellitic anhydride were polycondensed in a large amount of solvent (160 ml of sulfolane) to give pale yellow polyamideimide having a reduced viscosity of 1.056 dl/g in a yield of 97.6%.

JP-A-160140/1984 and 42424/1985 and corresponding EP-A-2 119,719 disclose a radiation-sensitive composition characterized by comprising:

(1) a polymer [I] containing repeating units (A) represented by the following formula:

$$\left[ CO-\underset{(COOR^3)_n}{R^1}-CONH-R^2-NH \right] \qquad (A)$$

wherein $R^1$ is a trivalent or tetravalent aromatic or heteroaromatic residue having 6 to 30 carbon atoms, $R^2$ is a divalent aromatic or heteroaromatic residue having 6 to 30 carbon atoms, $R^3$ is a hydrogen atom or an ammonium ion, n is an integer of 1 or 2, and $COOR^3$ is located in an ortho or peri position with respect to the amide linkage,

(2) an organic compound [II] having a radiation-dimerizable or radiation-polymerizable olefinic double bond and an amino radical or a quaternary ammonium salt, and

(3) an aromatic secondary or tertiary amine compound [III] which is chemically inactive with actinic radiation.

However, this document fails to give any specific description of a polyamide-imide between trimellitic anhydride and 3,4'-diaminodiphenylether as the polymer [I].

According to this invention, new polyamide imides having 3,4'-diaminodiphenyl ether as a diamine component, have now been devised.

Accordingly, the present invention provides a shapeable intimate mixture comprising:

(A) a polyamideimide comprising a unit of formula (II)

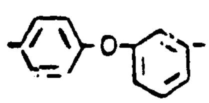

(II)

and a unit of formula (IV)

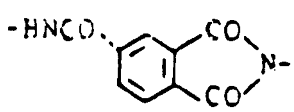

(IV)

wherein units of formulae (IV) and (II) provide at least 50% of the entire units forming the molecular chains of the polyamideimide and

(B) a plasticizing material for the polyamideimide (A) having a boiling point of least 300 ° C, a molecular weight of not more than 1,000, which is compatible, but substantially non-reactive, with the polyamideimide and which is selected from

- an imide compound formula (1)-a

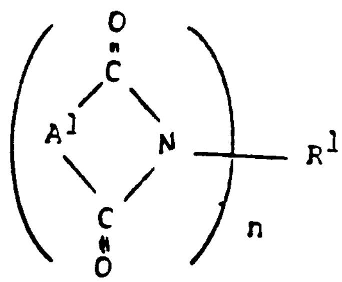

(I)-a

wherein $A^1$ is a divalent aromatic group which may be substituted, $R^1$ is an n-valent aromatic radical or linear or cyclic aliphatic radical which may be substituted, and n is 1 or 2, provided that the imide ring in the above formula is 5- or 6-membered,

- an imide compound of formula (1)-b

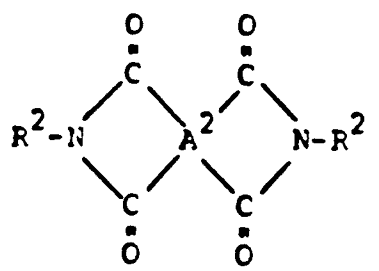

(1)-b

wherein $A^2$ is a tetravalent aromatic radical which may be substituted, and $R^2$ is a monovalent linear or cyclic aliphatic radical which may be substituted, provided that the imide ring in the above formula is 5- to 6-membered,

- a trialkyl isocyanurate of formula (I)-c

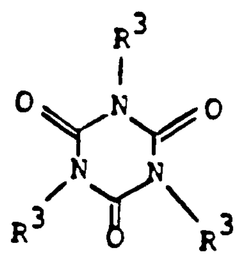

(1)-c

wherein $R^3$ is a monovalent alkyl group, and

- a diphenyl compound of formula (1)-d

$Ar-A^3-Ar$ (1)-d

wherein $A^3$ is -O-, $-SO_2-$, -CO- or an alkylene group and Ar is an aromatic radical;

the proportion of the polyamideimide (A) being 40 to 90% by weight based on the total amount of the polyamideimide (A) and plasticizing material (B).

In the polyamideimide (a) constituting the intimate mixture of this invention, the total proportion of the

unit of formula (IV) and the unit of formula (II) is at least 50% based on the entire units forming the polyamideimide molecular chains. Preferably, the proportion of the unit of formula (IV) and the unit of formula (II) directly bonded to each other is at least 50% based on the total proportion of the unit of formula (IV) and the unit of formula (II). Above all, it is preferred that the total proportion of the unit of formula (IV) and the unit of formula (II) directly bonded to each other be at least 50% based on the entire units forming the polyamideimide molecular chains.

The polyamideimide (a) may comprise the units of formulae (IV) and (II) as main units and other minor units.

The minor other unit is at least one unit selected from the group consisting of a unit represented by the following formula (V)

$-HNCO-Ar^1-CONH-Ar^2-$ (V)

wherein $Ar^1$ and $Ar^2$ are identical or different and each represents a divalent aromatic group having 6 to 20 carbon atoms,
a unit represented by the following formula (VI)

$-Ar^3-CONH-$ (VI)

whrein $Ar^3$ is the same as defined for $Ar^1$, a unit represented by the following formula (VII)

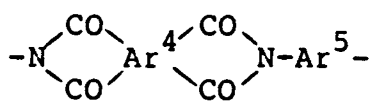 ..... (VII)

wherein $Ar^4$ represents a tetravalent aromatic group having 6 to 20 carbon atoms, and $Ar^5$ is the same as $Ar^1$,
and a unit represented by the following formula (VIII)

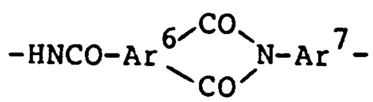 ..... (VIII)

wherein $Ar^6$ represents an aromatic group having 6 to 20 carbon atoms, and $Ar^7$ is the same as defined for $Ar^1$, provided that $Ar^7$ is not a 3,4'-diphenyl ether group.

These minor units are contained in a proportion smaller than the total proportion of the unit of formula (IV) and the unit of formula (II).

Examples of the aromatic groups having 6 to 20 carbon atoms represented by $Ar^1$ to $Ar^7$ in formulae (V) to (VIII) are a benzene ring and 2 or 3 benzene rings bonded to each other directly or via carbon, oxygen, sulfur, etc. More specifically, groups of the following formulae are suitable.

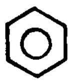, 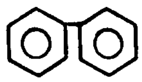, 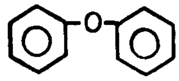, 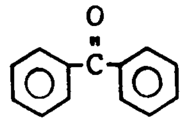,

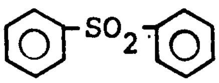, 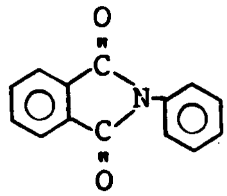, 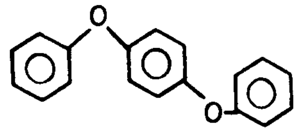.

A polyamideimide having higher heat resistance can be formed, for example, by introducing the unit of formula (VII) in which $Ar^4$ is

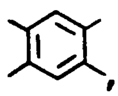, 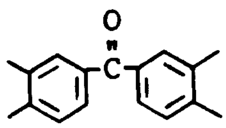

or 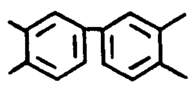.

Polyamideimides having higher alkali resistance or mechanical properties can be formed, for example, by introducing the unit of formula (V) in which $Ar^1$ is

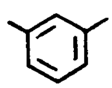 or 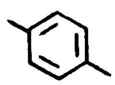,

or the unit of formula (VI) in which $Ar^3$ is

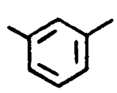 or 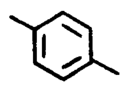.

The unit of formula (VIII) in which $Ar^6$ is

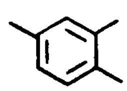

can also be introduced. $Ar^2$ in formula (V) and $Ar^4$ in formula (VII) may be a 3,4'-diphenylether group

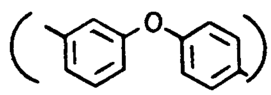

or another aromatic group, but $Ar^7$ in formula (VIII) is an aromatic group other than 3,4'-diphenyl ether group.

Such other aromatic groups are derived from diamines such as m-phenylenediamine, p-phenylenediamine, 4,4'-diaminodiphenylether, 3,3'-diaminodiphenylsulfone, 4,4'-diaminodiphenylsulfone, 3,3'-diaminobenzophenone, 4,4'-diaminobenzophenone, bis(m- or p-aminophenoxy)-1,3-benzene and bis(m- or p-aminophenoxy)-1,4-benzene.

The above polyamideimide has an inherent viscosity [$\eta_{inh}$], measured at 30 °C in N-methylpyrrolidone, of preferably at least 0.2, more preferably at least 0.3, especially preferably 0.4 to 1.5.

A polyamideimide having an inherent viscosity of less than about 0.2 does not give a self-supporting film, but even such a low-molecular-weight polyamideimide gives a flexible film by forming a film from it and then treating the film under heat or otherwise to induce after-polymerization or after-curing.

Polyamideimides which can be suitably used in this invention have a glass transition point of 150 to 300 °C. The glass transition point is measured by the TMA penetration method.

In general formula (1)-a for the plasticizer used in the present invention, examples of the divalent aromatic radical represented by $A^1$ are 1,2-phenylene, 1,2-, 2,3- or 1,3-naphthylene, and 5,6,7,8-tetrahydro-1,2- or 2,3-naphthylene groups. These groups may be substituted by substituents which are non-reactive with the polyamideimide. Examples of the substituents are lower alkyl groups such as methyl and ethyl, lower alkoxy groups such as methoxy and ethoxy, halogen atoms such as chlorine and bromine, a nitro group, a phenyl group, a phenoxy group and a cyclohexyl group which may be substituted by a methyl group.

Examples of the n-valent (n = 1 or 2) aromatic radical for $R^1$ include monovalent (n = 1) aromatic radicals such as a phenyl group, a naphthyl group, a 5,6,7,8-tetrahydro-1-, 2- or 3-naphthyl group and the groups

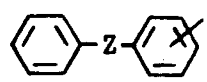

wherein Z is -O-, $-SO_2$ or $-CH_2-$, and divalent aromatic radicals such as 1,2-phenylene group, 1,2- 2,3- or 1,8-naphthylene groupu, a 5,6,7,8-tetrahydro-1,2-, or 2,3-naphthylene group and groups of the formula

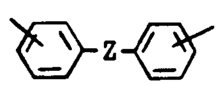

wherein Z is -O-, $-SO_2-$ or $-CH_2-$.

Examples of the n-valent (n = 1 or 2) aliphatic radical include monovalent aliphatic radicals for example linear alkyl groups having 1 to 18 carbon atoms such as methyl, ethyl, butyl, hexyl, heptyl, octyl, nonyl, decyl, dodecyl, myristyl and stearyl and 5- or 6-membered cycloalkyl groups such as cyclohexyl or cyclopentyl; and divalent aliphatic groups, for example linear alkylene groups having 2 to 12 carbon atoms such as ethylene, trimethylene, tetramethylene, hexamethylene, octamethylene, decamethylene and dodecamethylene, cycloalkylene groups such as a 1,3- or 1,4-cyclohexylene group, and the group

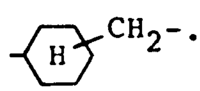

These groups represented by $R^1$ may be substituted by the same substituents as described above with regard to $A^1$. $R^1$ is preferably the aromatic radical rather than the aliphatic radical in view of the performance and heat resistance of the imide compounds as a molding aid.

In formula (1)-b for the plasticizer used in the present invention, examples of preferred tetravalent aromatic radical for $A^2$ are monocyclic, fused ring and polycyclic tetravalent aromatic groups represented by the following formula.

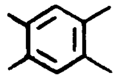 , 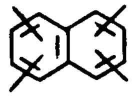 , 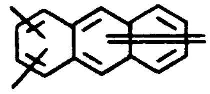 ,

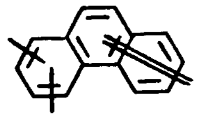 or 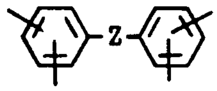

(Z is as defined hereinabove).

The same linear alkyl groups having 1 to 18 carbon atoms and 5- or 6-membered cyclic alkyl groups as exemplified above for $R^1$ in formula (1)-a may be cited as examples of the monovalent linear or cyclic aliphatic radical for $R^2$.

The groups exemplified with regard to $A^2$ and $R^2$ may be substituted by the same substituents as described above with regard to $A^1$.

Examples of the monovalent alkyl group for $R^3$ in formula (1)-c for the plasticizer used in the present invention are linear alkyl groups having 1 to 10 carbon atoms such as methyl, ethyl, propyl, butyl, hexyl, octyl and decyl.

Examples of the alkylene group for $A^3$ in formula (1)-d for the plasticizer used in the present invention are linear alkylene groups having 2 to 4 carbon atoms such as ethylene, trimethylene and tetramethylene. $A^3$ is preferably -O-, -$SO_2$- and -CO-. Ar in formula (1)-d is preferably the same as $R^1$ with $n = 1$ and may be substituted by the same substituents (e.g., phenylphenoxy, phenyl, or phenoxy) as defined for $A^1$.

Examples of the imide compounds of formula (1)-a include those in which n is 1, such as

N-methylphthalimide,
N-ethylphthalimide,
N-octylphthalimide,
N-laurylphthalimide,
N-myristylphthalimide,
N-stearylphthalimide,
N-ethyl-1,8-naphthalimide,
N-lauryl-1,8-naphthalimide,
N-myristyl-1,8-naphthalimide,
N-cetyl-1,8-naphthalimide, and
N-stearyl-1,8-naphthalimide;

and those in which n is 2, such as

N,N'-ethylenebisphthalimide,
N,N'-tetramethylenebisphthalimide,
N,N-hexamethylenebisphthalimide,
N,N'-octamethylenebisphthalimide,
N,N'-decamethylenebisphthalimide,
N,N'-dodecamethylenebisphthalimide,
N,N'-neopentylenebisphthalimide,
N,N'-tetramethylenebis(1,8-naphthalimide),
N,N'-hexamethylenebis(1,8-naphthalimide),
N,N'-octamethylenebis(1,8-naphthalimide),
N,N'-decamethylenebis(1,8-naphthalimide),
N,N'-dodecamethylenebis(1,8-naphthalimide),
N,N'-1,4-cyclohexylenebisphthalimide,
1-phthalimide-3-phthalimidemethyl-3,5,5-trimethylcyclohexane,
N,N'-2,2,4-trimethylhexamethylenebisphthalimide,
N,N'-2,4,4-trimethylhexaemethylenebisphthalimide,
4,4'-bisphehalimide diphenyl ether,
3,4'-bisphthalimide diphenyl ether,
3,3'-bisphthalimide diphenylsulfone, and
4,4'-bisphthalimide diphenylmethane.

Examples of the imide compounds represented by the formula (1)-b incluide

N,N'-diethylpyromellimide,
N,N'-dibutylpyromellitimide,

N,N'-dihexylpyromellitimide,
N,N'-dioctylpyromellitimide,
N,N'-didecylpyromellitimide,
N,N'-dilaurylpyromellitimide,
N,N'-dicyclohexyl pyromellitimide, and
N,N'-diethyl-1,4,5,8-naphthalenetetracarboxylic 1,8-, 4,5-diimide.

The imide compounds represented by formula (1)-a may be produced by a known method from the corresponding acid anhydrides and organic amines.

Examples of the compounds represented by formula (1)-c are triethyl isocyanurate, tributyl isocyanurate, trihexyl isocyanurate and trioctyl isocyanurate.

Examples of the compounds represented by formula (1)-d include diphenylsulfone, 4,4'-diphenoxydiphenylsulfone, 4,4'-bis(4- or 3- or 3-chlorophenoxy)diphenylsulfone, 4,4'-bis(4- or 3- or 2-phenylphenoxy)diphenylsulfone, 4,4'-bis(4- or 3- or 2-t-butylphenoxy)diphenylsulfone, 4,4'-bis(4- or 3- or 2-octylphenoxy)diphenylsulfone, and 4,4'-bis(alpha- or beta-naphthyloxy)diphenylsulfone.

Of the above, the compounds of formula (1)-d are preferred, and above all, diphenylsulfone is preferred.

The intimate mixture of this invention preferably contains the polyamideimide (A) in a proportion of 60 to 90% by weight, more preferably 60 to 80% by weight, based on the total amount of the polyamideimide (A) and the plasticizing material (B).

The intimate mixture of this invention can be produced by thermally condensing an acid component composed mainly of trimellitic acid and/or trimellitic anhydride and a diamine component composed mainly of 3,4'-diaminodiphenyl ether and/or its lower aliphatic carboxylic acid amide in the presence of the plasticizer described above.

The plasticizer is used in such a proportion that the concentration of the resulting polymer is preferably at last 50% by weight, more preferably at least 60% by weight, especially preferably at least 70% by weight.

The thermal condensation is carried out usually at 200 to 350 °C, preferably 250 to 320 °C, especially preferably 260 to 310 °C. Preferably, the thermal condensation is carried out under atmospheric pressure to elevated pressure, and as required, under such reduced pressures as not to cause evaporation of the plasticizing material. It is carried out in an atmosphere of an inert gas such as nitrogen or argon.

The thermal condensation reaction is desirably carried out in the presence of a small amount of a catalyst for promoting the reaction between the aromatic amino group and the carboxyl group, such as phosphorus compounds, boron compounds, or heteropolyacids. Examples of the phosphorus compounds are trimethyl phosphite, triethyl phosphite, triphenyl phosphite, phosphoric acid, triphenylphosphine, polyphosphoric acid, phosphoric acid, phosphorous acid and hypophosphorous acid. Boric acid is an example of the boron.

There can also be used a condensing agent which participates in the condensation reaction between the aromatic amino acid and the carboxyl group and itself changes to promote the amide-forming reaction. Examples of the condensing agent are a combination of triphenylphosphine and pyridine, diphenyl sulfite, diphenyl carbonate, diaryl esters of dicarboxylic acids such as diphenyl terephthalate, and compounds represented by the following formula

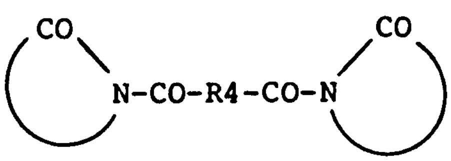

wherein $R^4$ represents an aromatic group having 6 to 20 carbon atoms, aliphatic groups having 2 to 10 carbon atoms, or a bond, and the two lactam rings are 5- to 7-membered,
such as

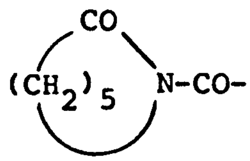 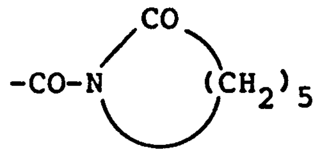 .

Water formed as a result of the thermal condensation reaction is removed out of the reaction system. The condensing agent is preferably added in such an amount that after removing water formed as a result of imidization, it induces reaction of the 4-carboxyl group of the trimellitic acid residue with all remaining amino groups.

According to this invention, the polyamideimide is obtained as an intimate mixture with a plasticizing material therefor. This intimate mixture is characterized by being shapable at temperature considerably lower, for example about 100°C lower, than the temperature at which the polyamideimide alone can be shaped. The plasticizing material can be removed by treating the shaped article or if required, small masses of the product before shaping, with a solvent capable of dissolving the plasticized product but incapable of dissolving the polyamideimide.

Examples of preferred solvents used for this purpose include aromatic hydrocarbons, halogenated aliphatic hydrocarbons, aliphatic ketones, aliphatic esters, and cyclic ethers. Specific examples are toluene, xylene, methylene chloride, chloroform, acetone, methyl ethyl ketone, methyl acetate, ethyl acetate and dioxane.

The polyamideimide used in this invention can be one which when undergoing heat-treatment after shaping, locally permits introduction of a crosslinked structure. Introduction of a crosslinked structure increases the heat resistance of the polymer in use. The easiest and most effective method of introducing such a crosslinked structure is to add an aromatic triamine or tetramine to the reaction mixture in the final stage of the polymerization reaction or to the resulting polymer, shape the polymer in the non-crosslinked state and heat-treat the shaped product thereby to introduce a crosslinked structure by reaction with the terminal groups.

Examples of such a triamine or tetramine are 2,4,4'-triaminodiphenyl ether, 1,3,5- or 1,2,4-triaminobenzene, and 3,3',4,4'-tetraminodiphenyl ether.

On the other hand, it is possible to use tri-functional or higher polycarboxylic acids (e.g., trimesic acid or its derivatives) for the aromatic amino groups as a crosslinking agent.

Conversely, if the reactive amino groups of the polymer are blocked by adding a highly reactive monofunctional compound such as a monoaryl carboxylate (e.g., phenyl benzoate), N-benzoyl caprolactone, or a dicarboxylic acid anhydride (e.g., phthalic anhydride) in the last stage of polymerization or during the molding of the polymer, the thermal stability of the polymer can be increased while inhibiting coloration.

The polyamideimide constituting the intimate mixture of this invention may be used in a wide range of applications, for example as a varnish, an adhesive, a film, fibers, a matrix resin for fiber-reinforced composite materials, and a molding resin for compression molding, extrusion, injection molding, etc.

As a varnish, the polyamideimide is used as a solution in N-methylpyrrolidone or cresol as a main solvent as an enamelling varnish for wires and cables, and as an enamel for aluminum utensils. The polymer in powder form may be used for coating a metallic surface by applying the powdery polymer to the surface and then baking it.

Films and fibers may be shaped from a solution of the polymer by the wet or dry method. They can be used for electrical insulation and as protective apparel by utilizing the good heat resistance and fire retardancy of the polymer.

As an adhesive, the polyamideimide may be used as a dry film adhesive, or as a solution adhesive to be coated on an adhrend, dried and then thermally melt-bonded. The adherend may, for example, be metals, especially iron, aluminum, stainless steel and copper.

When the polyamideimide is used as a matrix resin for fiber-reinforced composite materials, the polymer in the form of a solution or a powder fluidized layer is applied to the surface of reinforcing fibers to form strands, unidirectional prepregs, etc, and molded articles can be obtained from them by various techniques such as autoclave molding, press-forming, or filament winding.

As a molding resin, molding compounds are prepared together with various additives, and shaped by compression molding, extrusion, injection molding, etc.

The molded articles described above have a well balanced combination of heat resistance, mechanical properties and chemical resistance, and can be widely used in advanced technological fields as functional component parts of various transporting machines such as aircraft, spacecraft, automobiles and ships,

electrical, electronic and automation instruments and appliances and sporting goods.

In actual use, the polymers may be used as blends with various additives and other polymers.

The following Examples illustrate the present invention more specifically.

EXAMPLE 1

A reactor equipped with a stirrer, a nitrogen gas introducing opening and a distillation opening was charged with 20.0g of 3,4'-diaminodiphenyl ether, 19.2g of trimellitic anhydride, 0.2g of triphenyl phosphate, and 15.3g of diphenylsulfone. After purging the inside of the reactor well with nitrogen, the reaction was carried out at 280° C for 2 hours in a stream of nitrogen gas while water formed was distilled out of the reaction system. The resulting composition was transparent. The composition was then pulverized to a size of 10 to 20 mesh, immersed in acetone and extracted under heat. The resulting polymer had an inherent visosity, measured at 30° C in NMP in a concentration of 0.5 g/dl, of 0.64.

COMPARATIVE EXAMPLE 1

The same reaction as in Example 1 was carried out except that 4,4'-diaminodiphenyl ether was used instead of 3,4'-diaminodiphenyl ether. In about 30 minutes after the start of the reaction, the reaction system solidified and became unable to be stirred uniformly.

EXAMPLES 2-5

Example 1 was repeated except that a predetermined amount of each of he compounds shown in Table 1 below was used instead of 15.3 g of diphenylsulfone, and the reaction was carried out under the reaction conditions shown in Table 1. The resulting compositions were transparent. The compositions were each extracted with acetone in the same way as in Example 1, and the resulting polymers had the inherent viscosities shown in Table 1.

Table 1

| Example | Low-molecular-weight compound (amount added) | Reaction conditions | | $\eta_{inh}$ |
|---|---|---|---|---|
| | | Temp. (° C) | Time (hrs) | |
| 2 | Diphenylsulfone (8.9 g) | 290 | 2 | 0.63 |
| 3 | Diphenylsulfone (24.0 g) | 280 | 7 | 0.68 |
| 4 | 4,4'-bis-(p-phenylphenoxy)diphenylsulfone (15.3 g) | 290 | 2 | 0.61 |
| 5 | 4,4'-Diphenoxydiphenylsulfone (15.3 g) | 280 | 3 | 0.66 |

EXAMPLES 6 AND 7

The same reactor as used in Example 1 was charged with the material shown in Table 2, 15.3g of diphenylsulfone and 0.5g of triphenyl phosphite, and the same reaction and extraction as in Example 1 were carried out. The intrinsic viscosities of the resulting polymers are shown in Table 2.

Table 2

| Example | Materials | $\eta_{inh}$ |
|---|---|---|
| 6 | 3,4'-diaminodiphenylether (16.0 g)<br>m-phenylenediamine (2.2 g)<br>trimellitic anhydride (19.2 g) | 0.48 |
| 7 | 3,4'-diaminodiphenyl ether (20.0 g)<br>trimellitic anhydride (17.3 g)<br>diphenyl isophthalate (3.2 g) | 0.62 |

Example 8

The same reactor as in Example 1 was charged with 20.0g of 3,4'-diaminodiphenyl ether, 19.0g of trimellitic anhydride, 23.7g of diphenylsulfone and 0.2g of triphenyl phosphite, and they were reacted at 270°C for 1 hour in a stream of nitrogen gas. At this point, part of the polymer composition was sampled and extracted, and its inherent viscosity was measured. It was 0.29. Then, 2g of N,N'-terephthaloyl biscaprolactam was added, and the mixture was reacted for 30 minutes. After the extracting treatment, the polymer had an inherent viscosity of 0.67.

EXAMPLE 9

The same polyamideimide (inherent viscosity 0.61) as obtained in Example 1 and a mixture of the polyamideimide with 30% by weight of glass fibers were each injection-molded at a cylinder temperature of 280 to 310°C and a mold temperature of 165°C. The resulting molded articles had the properties shown in Table 3.

Table 3

| Property | Polyimide alone | Mixture of the polyimide and glass fibers |
|---|---|---|
| Tensile sgtrength (kg/cm$^2$) | 720 | 1130 |
| Elongation (%) | 4.7 | 3.0 |
| Flexural strength (kg/cm$^2$) | 1150 | 1520 |
| Flexural modulus (kg/cm$^2$) | 41000 | 100000 |
| Heat distortion temperature (°C) | 208 | 221 |

**Claims**

**1.** A shapeable intimate mixture comprising

(A) a polyamideimide comprising a unit of formula (II)

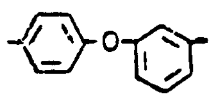

(II)

and a unit of formula (IV)

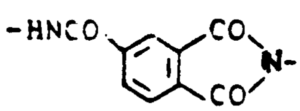

(IV)

wherein units of formulae (IV) and (II) provide at least 50% of the entire units forming the molecular chains of the polyamideimide and

(B) a plasticizing material for the polyamideimide (A) having a boiling point of least 300°C, a molecular weight of not more than 1000, which is compatible, but substantially non-reactive, with the polyamideimide and which is selected from

- an imide compound formula (1)-a

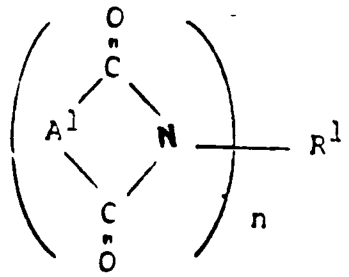

(I)-a

wherein $A^1$ is a divalent aromatic group which may be substituted, $R^1$ is an n-valent aromatic radical or linear or cyclic aliphatic radical which may be substituted, and n is 1 or 2, provided that the imide ring in the above formula is 5- or 6-membered,

- an imide compound of formula (1)-b

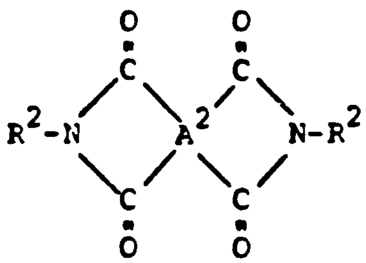

(1)-b

wherein $A^2$ is a tetravalent aromatic radical which may be substituted, and $R^2$ is a monovalent linear or cyclic aliphatic radical which may be substituted, provided that the imide ring in the above formula is 5- or 6-membered,

- a trialkyl isocyanurate of formula (I)-c

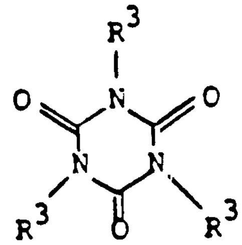

(1)-c

wherein $A^3$ is a monovalent alkyl group, and

- a diphenyl compound of formula (1)-d

Ar-$A^3$-Ar (1)-d

wherein $R^3$ is -O-, -$SO_2$-, -CO- or an alkylene group and Ar is an aromatic radical;

the proportion of the polyamideimide (A) being 40 to 90% by weight based on the total amount of the polyamideimide (A) and plasticizing material (B).

2. An intimate mixture according to claim 1 wherein the proportion of the unit of formula (IV) and the unit of formula (II) directly bonded to each other is at least 50% of the total proportion of the unit of formula (IV) and the unit of formula (II).

3. An intimate mixture according to claim 1 wherein the total proportion of the unit of formula (IV) and the unit of formula (II) directly bonded to each other is at least 50% based on the entire units forming the molecular chains of the polyamideimide.

4. An intimate mixture according to any one of claims 1 to 3 wherein the polyamideimide has an inherent

viscosity, measured at 30 ° C in N-methylpyrrolidone, of at least 0.2.

**5.** An intimate mixture according to any one of claims 1 to 4 wherein the polyamideimide further comprises at least one unit selected from a unit of formula (V)

$-HNCO-Ar^1-CONH-Ar^2-$ (V)

wherein $Ar^1$ and $Ar^2$ are identical or different and each represents a divalent aromatic group having 6 to 20 carbon atoms,
a unit of formula (VI)

$-Ar^3-CONH-$ (VI)

wherein $Ar^3$ is the same as $Ar^1$, a unit of formula (VII)

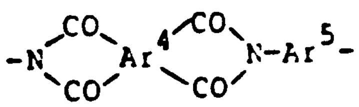

(VII)

wherein $Ar^4$ represents a tetravalent aromatic group having 6 to 20 carbon atoms, and $Ar^5$ is the same as $Ar^1$,
and a unit of formula (VIII)

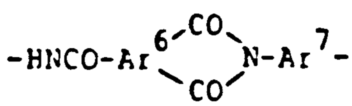

(VIII)

wherein $Ar^6$ represents an aromatic group having 6 to 20 carbon atoms, and $Ar^7$ is the same as $Ar^1$, provided that $Ar^7$ is not a 3,4'-diphenyl ether group,
the proportion of said at least one unit being smaller than the total proportion of the unit of formula (IV) and the unit of formula (II).

**6.** An intimate mixture according to any one of claims 1 to 6 wherein the proportion of the polyamideimide (A) is 60 to 90% by weight based on the total amount of the polyamideimide (A) and the plasticizing material (B).

## Revendications

**1.** Mélange intime façonnable comprenant
(A) un poly(amide-imide) comportant un motif de formule (II)

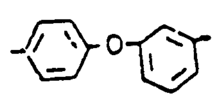

(II)

et un motif de formule (IV)

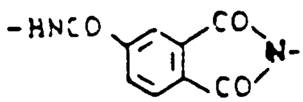

(IV),

dans lequel les motifs de formules (IV) et (II) fournissent au moins 50% de la totalité des motifs composant les chaînes moléculaires du poly(amide-imide), et

(B) un matériau servant de plastifiant pour le poly(amide-imide) (A), qui a un point d'ébullition d'au moins 300 ° C et une masse moléculaire ne dépassant pas 1000, qui est compatible avec le poly-(amide-imide), mais ne réagit pratiquement pas avec lui, et qui est choisi parmi:

- un composé imide de formule (I)-a

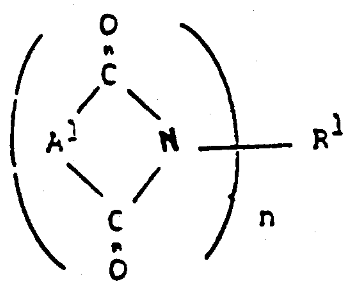

(I)-a

dans laquelle $A^1$ est un groupe aromatique divalent, qui peut être substitué, $R^1$ est un radical aromatique de valence n ou un radical aliphatique, cyclique ou linéaire, qui peut être substitué, et n vaut 1 ou 2, à la condition que, dans la formule ci-dessus, le cycle imide présente 5 ou 6 chaînons,

- un composé imide de formule (I)-b

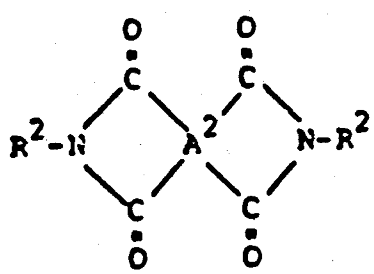

(I)-b

dans laquelle $A^2$ est un radical aromatique tétravalent, qui peut être substitué, et $R^2$ est un radical aliphatique monovalent, cyclique ou linéaire, qui peut être substitué, à la condition que, dans la formule ci-dessus, le cycle imide présente 5 ou 6 chaînons,

- un isocyanurate de trialkyle de formule (I)-c

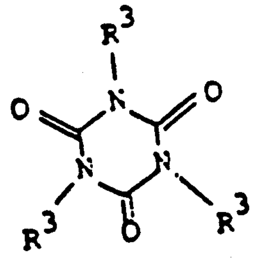

(I)-c

dans laquelle $A^3$ est un groupe alkyle monovalent,
et

- un composé diphénylique de formule (I)-d

$Ar-A^3-Ar$ (I)-d

dans laquelle $A^3$ est -O-, $-SO_2-$, -CO- ou un groupe alkylène et Ar est un radical aromatique,
la proportion du poly(amide-imide) (A) représentant 40 à 90% en poids par rapport à la somme des quantités du poly(amide-imide) (A) et du matériau plastifiant (B).

2. Mélange intime selon la revendication 1, dans lequel la proportion de motifs de formule (IV) et de motifs de formule (II) directement liés les uns aux autres représente au moins 50% de la somme des proportions de motifs de formule (IV) et de motifs de formule (II).

3. Mélange intime selon la revendication 1, dans lequel la proportion de motifs de formule (IV) et de motifs de formule (II) directement liés les uns aux autres représente au moins 50% de la totalité des motifs composant les chaînes moléculaires du poly(amide-imide).

4. Mélange intime selon l'une quelconque des revendications 1 à 3, dans lequel le poly(amide-imide) présente une viscosité inhérente d'au moins 0,2, déterminée à 30 ° C dans la N-méthylpyrrolidone.

5. Mélange intime selon l'une quelconque des revendications 1 à 4, dans lequel le poly(amide-imide) comporte de plus au moins un motif,
choisi parmi

- un motif de formule (V)

$-HNCO-Ar^1-CONH-Ar^2-$ (V)

dans laquelle $Ar^1$ et $Ar^2$ sont identiques ou différents, et représentent chacun un groupe aromatique divalent ayant 6 à 20 atomes de carbone,

- un motifs de formule (VI)

$-Ar^3-CONH-$ (VI)

dans laquelle $Ar^3$ est identique à $Ar^1$,

- un motif de formule (VII)

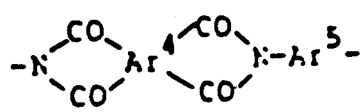

(VII)

dans laquelle $Ar^4$ représente un groupe aromatique tétravalent ayant 6 à 20 atomes de carbone, et $Ar^5$ est identique à $Ar^1$,
et

- un motif de formule (VIII)

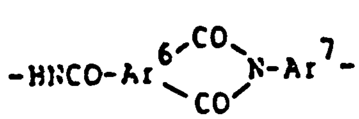

(VIII)

dans laquelle $Ar^6$ représente un groupe aromatique ayant 6 à 20 atomes de carbone, et $Ar^7$ est

identique à $Ar^1$, à la condition que $Ar^7$ ne soit pas un groupe éther 3,4'-diphénylique, la proportion dudit motif au nombre d'au moins un étant plus petite que la somme des proportions de motifs de formule (IV) et de motifs de formule (II).

**6.** Mélange intime selon l'une quelconque des revendications 1 à 5, dans lequel la proportion du poly(amide-imide) (A) représente 60 à 90% en poids par rapport à la somme des quantités de poly(amide-imide)(A) et de matériau plastifiant (B).

**Patentansprüche**

**1.** Formbares inniges Gemisch, umfassend
A) ein Polyamidimid, umfassend eine Einheit der Formel (II)

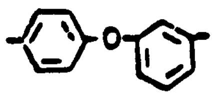

(II)

und eine Einheit der Formel (IV)

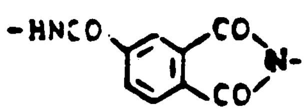

(IV)

wobei Einheiten der Formeln (IV) und (II) zumindest 50% der gesamten Einheiten, die die molekularen Ketten des Polyamidimids bilden, ausmachen, und
(B) ein weichmachendes Material für das Polyamidimid (A) mit einem Siedepunkt von mindestens 300 °C, einem Molekulargewicht von nicht mehr als 1000, das verträglich ist, aber im wesentlichen nicht reagiert, mit dem Polyamidimid und das ausgewählt ist aus

- einer Imidverbindung der Formel (I)-a

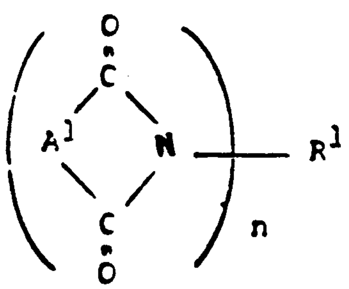

(I)-a

wobei $A^1$ eine zweiwertige aromatische Gruppe ist, die substituiert sein kann, $R^1$ einen n-wertigen aromatischen Rest oder einen linearen oder cyclischen aliphatischen Rest, der substituiert sein kann, bedeutet, und n 1 oder 2 ist, mit der Maßgabe, daß der Imidring in der obigen Formel 5- oder 6-gliedrig ist,

- einer Imidverbindung der Formel (I)-b

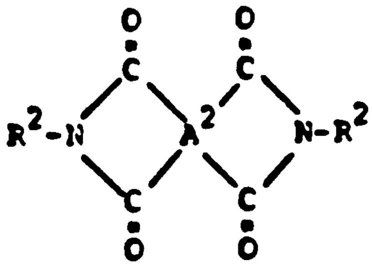

(I)-b

in der $A^2$ einen vierwertigen aromatischen Rest bedeutet, der substituiert sein kann, und $R^2$ einen einwertigen linearen oder cyclischen aliphatischen Rest, der substituiert sein kann, mit der Maßgabe, daß der Imidring in der obigen Formel 5- oder 6-gliedrig ist,

- einem Trialkylisocyanurat der Formel (I)-c

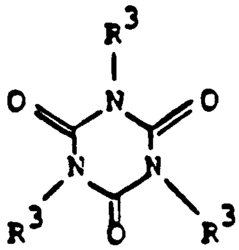

(I)-c

wobei $A^3$ eine einwertige Alkylgruppe ist, und

- einer Diphenylverbindung der Formel (I)-d

Ar-$A^3$-Ar (I)-d)

wobei $R^3$ = -O-, -$SO_2$-, -CO- oder eine Alkylengruppe ist und Ar einen aromatischen Rest bedeutet;

wobei der Anteil an Polyamidimid (A) 40 bis 90 Gew.-%, bezogen auf die Gesamtmenge an Polyamidimid (A) und weichmachendem Material (B), beträgt.

**2.** Inniges Gemisch nach Anspruch 1, wobei der Anteil der Einheiten der Formel (IV) und der Einheiten der Formel (II), die direkt aneinander gebunden sind, mindestens 50 Gew.-% der Gesamtmenge der Einheiten der Formel (IV) und der Einheiten der Formel (II) beträgt.

**3.** Inniges Gemisch nach Anspruch 1, wobei der Gesamtanteil der Einheiten der Formel (IV) und der Einheiten der Formel (II), die direkt miteinander verbunden sind, mindestens 50%, bezogen auf die gesamten Einheiten, die die molekularen Ketten des Polyamidimids bilden, beträgt.

**4.** Inniges Gemisch nach einem der Ansprüche 1 bis 3, wobei das Polyamidimid eine logarithmische Viskositätszahl, gemessen bei 30 °C in N-Methylpyrrolidon, von mindestens 0,2 aufweist.

**5.** Inniges Gemisch nach einem der Ansprüche 1 bis 4, wobei das Polyamidimid ferner umfaßt mindestens eine Einheit, ausgewählt aus einer Einheit der Formel (V)

-HNCO-$Ar^1$-CONH-$Ar^2$- (V)

in der $Ar^1$ und $Ar^2$ gleich oder verschieden sind und jeweils eine zweiwertige aromatische Gruppe mit 6 bis 20 Kohlenstoffatomen bedeuten,
einer Einheit der Formel (VI)

-$Ar^3$-CONH- (VI)

wobei $Ar^3$ gleich ist wie $Ar^1$,

einer Einheit der Formel (VII)

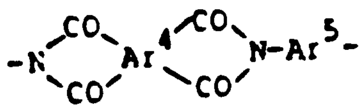

(VII)

wobei $Ar^4$ eine vierwertige aromatische Gruppe mit 6 bis 20 Kohlenstoffatomen bedeutet und $Ar^5$ gleich ist wie $Ar^1$,
und einer Einheit der Formel (VIII)

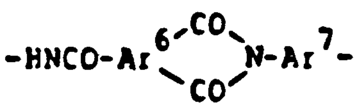

(VIII)

wobei $Ar^6$ eine aromatische Gruppe mit 6 bis 20 Kohlenstoffatomen bedeutet, und $Ar^7$ gleich ist wie $Ar^1$, mit der Maßgabe, daß $Ar^7$ keine 3,4'-Diphenylethergruppe ist,
wobei der Anteil der zumindest einen Einheit kleiner ist als die Gesamtmenge der Einheiten der Formel (IV) und der Einheiten der Formel (II).

**6.** Inniges Gemisch nach einem der Ansprüche 1 bis 6, wobei der Anteil des Polyamidimids (A) 60 bis 90 Gew.-%, bezogen auf die Gesamtmenge des Polyamidimids (A) und des weichmachenden Materials (B), beträgt.